# EUROPÄISCHE PATENTANMELDUNG

(11) **EP 2 608 276 A1**
(43) Veröffentlichungstag der Anmeldung: **26.06.2013**
(21) Anmeldenummer: 11195475.6
(22) Anmeldetag: 23.12.2011
(51) Int. Cl.: H01L 31/048, B32B 27/34, B32B 27/30, C08L 77/06, C08L 77/02

(54) **Photovoltaikmodul-Rückfolie, Verfahren zu deren Herstellung sowie deren Verwendung bei der Produktion photovoltaischer Module**

(71) Anmelder: EMS-Patent AG, 7013 Domat/Ems (CH)
(72) Erfinder: Dr. rer. nat. Stöppelmann Georg, 7402 Bonaduz (CH); Dipl. Ing. FH Garcia Gabriel, Domat/Ems (CH); Dipl. Ing. FH Pfleghar Mark, 7013 Domat/Ems (CH)
(74) Vertreter: OK pat AG

(57) **Zusammenfassung**

Es wird eine Photovoltaikmodul-Rückfolie vorgeschlagen, welche mindestens eine Schicht enthält die aus einer Polyamid-Formmasse hergestellt ist, wobei diese Polyamid-Formmasse zusammengesetzt ist aus 15 bis 70 Gewichtsprozent mindestens eines transparenten Polyamids, dessen Glasübergangstemperatur auch nach der Aufnahme von Feuchtigkeit bei 85°C und 85 % relativer Feuchtigkeit mehr als 100°C beträgt, 15 bis 70 Gewichtsprozent mindestens eines aliphatischen Polyamids, 0.5 bis 3 Gewichtsprozent an UV- und Hitzestabilisatoren und 10 bis 30 Gewichtsprozent mindestens eines weiteren Zusatzstoffes, und sich die Komponenten auf 100 Gewichtsprozent der Polyamid-Formmasse ergänzen. Derartige Photovoltaikmodul-Rückfolien eignen sich zur Herstellung von Photovoltaikmodulen mit stark reduzierter Vergilbung.

## Beschreibung

Die Erfindung betrifft photovoltaische Module, d.h. Solarzellenmodule zur photoelektrischen Stromerzeugung aus Sonnenlicht. Ein Photovoltaikmodul (PV-Modul) ist üblicherweise tafelförmig (relativ dünn und grossflächig) als Laminat aufgebaut und umfasst typischerweise von vorne (d.h. von der Lichteinfallseite her) nach hinten: eine transparente Scheibe (z.B. aus Spezialglas), eine haftvermittelnde Folie (bevorzugt aus Ethylenvinylacetat EVA, einem Copolymer das elastisch und transparent ist), eine oder mehrere Solarzellen (in der Regel Siliziumscheiben), eine weitere Haftvermittlerfolie (bevorzugt EVA), und schliesslich die Rückfolie ("backsheet"), welche aus dafür geeigneten Kunststoffen besteht und die rückseitige Schutzschicht des Moduls darstellt. Zwischen den beiden elastischen EVA-Schichten sind die Solarzellen eingebettet. Bei der in einer Presse durchgeführten thermischen Verklebung der Glasplatte und der Rückfolie über die EVA-Schichten (und der EVA-Schichten untereinander in den Zwischenräumen zwischen oder neben den Solarzellen sowie auch mit den Solarzellen selbst) werden die Solarzellen nach der Verfestigung des Verbundes zwischen den vorderseitigen und rückseitigen Laminatschichten in EVA eingekapselt. Durch das Glas und die Rückfolie wird die Solarzelle gegen den Eintritt von Feuchtigkeit versiegelt. Die Rückfolie kann einschichtig (als Monofolie) oder mehrschichtig ausgebildet sein. Eine Rückfolie eines solchen photovoltaischen Moduls ist Gegenstand der vorliegenden Erfindung.

Ein repräsentatives Dokument für den Stand der Technik auf diesem Gebiet ist die Patentschrift EP 2 275 471 B1. In der Einleitung dieses Dokuments wird auch der weitere einschlägige Stand der Technik in einem Überblick zitiert. Das Dokument EP 2 275 471 B1 befasst sich mit einer Photovoltaikmodul-Monorückfolie, die aus einer auf Polyamid (PA) basierenden Formmasse hergestellt ist. Als Beispiele wurden Rückfolien aus vernetztem PA12 und PA1010 gearbeitet.

Rückfolien auf Basis von PVF/PET-Verbunden sind ein schon länger verbreiteter Stand der Technik, z.B. die bekannte Tedlar®-Folie, die meist als dreischichtige Rückfolie (PVF/PET/PVF) zum Einsatz kommt. Diese Rückfolie wird zusammen mit der Solarzelle und der vorderen Glasplatte mit jeweils dazwischen liegendem Ethylen-Vinylacetat-Copolymer (EVA) verschweisst, d.h. in einem Laminierverfahren heiss verpresst und über das EVA als Haftvermittler der ganze Schichtaufbau verklebt.

Ein neueres Rückfoliensystem basiert auf ein- oder mehrschichtigen Folien aus Polyamid; im bereits erwähnten Dokument EP 2 275 471 B1 werden Monofolien beschrieben. Die zum Prioritätszeitpunkt der vorliegenden Anmeldung noch nicht ver-öffentlichte Anmeldung EP 11159544.3 des gleichen Anmelders beschreibt Mehrschichtfolien mit PA in den Aussenschichten. Die PA-Schichten dieser Rückfolien enthalten neben Titandioxid zur Erzielung eines möglichst hohen Reflexionsgrades auch Hitze- und UV-Stabilisatoren, wie in EP 2 275 471 B1 angegeben ist. Durch diese Stabilisatoren soll eine möglichst lange Lebensdauer dieser Rückfolien und eine geringe Verfärbung gewährleistet werden. Die Vergilbung von Polyamiden bei höheren Temperaturen (ab ca. 80 °C) wurde in den Aufbauten gemäss der EP 11159544.3 durch Einbau einer als Sauerstoffbarriere fungierenden Innenschicht unterdrückt.

Trotz der getroffenen Massnahmen, Polyamide gegen die schädliche Wirkung von Hitze und UV-Strahlung zu stabilisieren und bei höheren Temperaturen den Kontakt mit Luftsauerstoff zu vermeiden hat sich gezeigt, dass nach Hitzelagerung in feuchtem Klima von entsprechenden Testlaminaten mit Rückfolien aus verschiedenen Polyamiden (Glasplatte plus EVA-Folie plus PA-Rückfolie) jeweils durch die Glasplatte hindurch eine unerklärlich starke Vergilbung zu sehen war, welche in Form des Yellow Index quantifiziert wurde.

Es war die Aufgabe der vorliegenden Erfindung, dieses unerklärte Vergilbungsphänomen weitgehend zu unterbinden und eine auf Basis einer Polyamid-Formmasse hergestellte verbesserte Photovoltaikmodul-Rückfolie zur Verfügung zu stellen, die den erwähnten Nachteil nicht oder nur in deutlich verringertem Ausmass aufweist.

Diese Aufgabe wird gemäss der vorliegenden Erfindung mit einer Photovoltaikmodul-Rückfolie mit den Merkmalen von Anspruch 1 gelöst. Die erfindungsgemässe Photovoltaikmodul-Rückfolie enthält mindestens eine Schicht die aus einer Polyamid-Formmasse hergestellt ist, dadurch gekennzeichnet dass diese Polyamid-Formmasse zusammengesetzt ist aus:
- 25 bis 70 Gewichtsprozent mindestens eines transparenten Polyamids (A), dessen Glasübergangstemperatur (Tg) auch nach der Aufnahme von Feuchtigkeit bei 85°C und 85 % relativer Feuchtigkeit mehr als 100°C beträgt;
- 15 bis 58 Gewichtsprozent mindestens eines aliphatischen Polyamids (B);
- 0.5 bis 3 Gewichtsprozent an UV- und Hitzestabilisatoren (C); und
- 10 bis 30 Gewichtsprozent mindestens eines weiteren Zusatzstoffes (D); wobei sich die Komponenten (A) bis (D) auf 100 Gewichtsprozent der Polyamid-Formmasse ergänzen.

Weitere bevorzugte Merkmale und Ausführungsformen der erfindungsgemässen Photovoltaikmodul-Rückfolie ergeben sich aus den abhängigen Ansprüchen. Zudem werden ein Verfahren zu deren Herstellung sowie deren Verwendung bei der Produktion photovoltaischer Module beansprucht.

Das mindestens eine transparente Polyamid (A) ist bevorzugt ausgewählt aus einer Gruppe, die aus PA MACM 12, PA PACM 12, PA MACM I, PA MACM T und Mischungen daraus besteht, und das mindestens eine aliphatische Polyamid (B) ist bevorzugt ausgewählt aus einer Gruppe, die aus PA 11, PA 12, PA 1010, PA 1012 und Mischungen daraus besteht.

Bevorzugt ist das mindestens eine transparente Polyamid (A) amorph. Unter amorphen Polyamiden werden solche Polyamide verstanden, die in der Dynamischen Differenz-Kalorimetrie (Differential Scanning Calorimetry, DSC) nach ISO 11357 bei einer Aufheizrate von 20 K/min eine Schmelzwärme von maximal 5 J/g, bevorzugt maximal 3 J/g und besonders bevorzugt maximal 1 J/g aufweisen.

In einer bevorzugten Ausführungsform enthält die Polyamid-Formmasse in ihrer Zusammensetzung eine Mischung von 26 bis 68 Gewichtsprozent des Polyamids (A) und 16 bis 50 Gewichtsprozent des Polyamids (B), besonders bevorzugt von 28 bis 65 Gewichtsprozent des Polyamids (A) und 17 bis 40 Gewichtsprozent des Polyamids (B) und ganz besonders bevorzugt von 53 bis 63 Gewichtsprozent des Polyamids (A) und 18 bis 30 Gewichtsprozent des Polyamids (B), wobei sich die Gewichtsprozente jeweils auf 100 Gewichtsprozent der Polyamid-Formmasse beziehen, die auch 0.5 bis 3 Gewichtsprozent der Komponente (C) und 10 bis 30 Gewichtsprozent der Komponente (D) enthält.

In einer besonders bevorzugten Variante der obigen Ausführungsform enthält die Polyamid-Formmasse in ihrer Zusammensetzung eine Mischung von 26 bis 68 Gewichtsprozent PA MACM 12 als Polyamid (A) und 16 bis 50 Gewichtsprozent PA 12 als Polyamid (B), besonders bevorzugt von 28 bis 65 Gewichtsprozent PA MACM 12 als Polyamid (A) und 17 bis 40 Gewichtsprozent PA 12 als Polyamid (B) und ganz besonders bevorzugt von 53 bis 63 Gewichtsprozent PA MACM 12 als Polyamid (A) und 18 bis 30 Gewichtsprozent PA 12 als Polyamid (B), wobei sich die Gewichtsprozente jeweils auf 100 Gewichtsprozent der Polyamid-Formmasse beziehen, die auch 0.5 bis 3 Gewichtsprozent der Komponente (C) und 10 bis 30 Gewichtsprozent der Komponente (D) enthält.

Bevorzugt ist eine Ausführungsform, bei welcher die Polyamidformmasse keine anderen Polyamide als PA MACM 12 und PA 12 enthält.

Vorzugsweise sind die UV- und Hitzestabilisatoren (C) ausgewählt aus der Gruppe bestehend aus den Klassen der Diphosphite, Diphosphonite, Oxanilide, sterisch gehinderten Aminen, sterisch gehinderten Phenolen und Mischungen daraus, und besonders bevorzugt ausgewählt aus der Gruppe bestehend aus [4-[4-bis(2,4-ditert-butylphenoxy)phosphanylphenyl] phenyl]-bis(2,4-ditert-butylphenoxy)phosphan; Bis(2,4-dicumylphenyl)pentaerythritol diphosphit; 2-Ethyl-2'-ethoxy-oxalanilid; 1,3-Benzendicarboxamid, N,N'-bis(2,2,6,6-tetramethyl-4-piperidinyl; N,N'-hexan-1,6-diylbis [3-(3, 5-di-tert-butyl-4-hydroxyphenyl)propionamid] und Mischungen daraus. Die entsprechenden Handelsnamen sind nach der Tabelle 1 mit den eingesetzten Materialien angegeben.

Der mindestens eine weitere Zusatzstoff (D) ist bevorzugt ausgewählt aus einer Gruppe, die aus Weisspigmenten, UV-Absorbern, Hydrolysestabilisatoren, Vernetzungsaktivatoren, Flammschutzmitteln, Schichtsilikaten, Füllstoffen, Farbmitteln, Verstärkungsmitteln, Haftvermittlern, Schlagzähigkeitsmodifikatoren, Gleitmitteln, Fluorpolymeren und Mischungen daraus besteht.

Als Weisspigment ist Titandioxid in der Rutil- oder Anatas-Modifikation bevorzugt. Die Photovoltaikmodul-Rückfolie enthält in der Schicht aus der Polyamid-Formmasse bevorzugt mindestens ein Weisspigment, und weist insbesondere einen Reflexionsgrad von mindestens 92 % auf. Der Reflexionsgrad wurde bei der vorliegenden Erfindung gemäss der DIN 5033 (Teil 7) auf einem Spektrophotometer der Firma Datacolor (Gerätebezeichnung: Datacolor 650) unter den folgenden Messbedingungen vor einem weisslackierten Kontrastblech bestimmt, Messmodus: Reflexion, Messgeometrie: D/8°, Lichtart: D 65 10, Glanz: eingeschlossen, Kalibrierung: UVkalibriert, Messblende: SAV.

Titandioxid ist bevorzugt in einem Anteil von 15 bis 25 Gewichtsprozent, besonders bevorzugt von 18 bis 22 Gewichtsprozent und ganz besonders bevorzugt von 19 bis 21 Gewichtsprozent in der Schicht aus der Polyamid-Formmasse enthalten.

Die erfindungsgemässe Photovoltaikmodul-Rückfolie besteht aus einer einzigen Schicht oder aus mehreren Schichten.

In einer bevorzugten Ausführungsform grenzt die mindestens eine Schicht der Rückfolie, die aus einer Polyamid-Formmasse hergestellt ist, in einem laminierten Photovoltaikmodul direkt an eine EVA-Schicht.

Vorzugsweise ist der Yellow Index nach 15-minütigem Laminieren bei einer Pressentemperatur von 150°C und anschliessender Lagerung während 1000 Stunden bei 85°C und 85 % relativer Feuchtigkeit kleiner als 11, bevorzugt kleiner als 9 und besonders bevorzugt kleiner als 6. Der Yellow Index wurde nach ASTM D1925 gemessen, und zwar durch die Glasplatte des PV-Moduls hindurch.

Bei einem bevorzugten Verfahren zur Herstellung einer Photovoltaikmodul-Rückfolie auf Basis einer erfindungsgemässen Polyamid-Formmasse wird diese Polyamid-Formmasse extrudiert oder coextrudiert.

Eine erfindungsgemässe Photovoltaikmodul-Rückfolie oder ein Verfahren zu deren Herstellung wird bevorzugt bei der Produktion photovoltaischer Module verwendet.

In den durch die Erfinder durchgeführten Untersuchungen wurde neben den bereits diskutierten Auslösefaktoren für die Vergilbung (Hitze, UV-Strahlung und Oxidation durch Luftsauerstoff) ein weiterer Vergilbungsweg identifiziert. Es hat sich gezeigt, dass die zur Langzeitstabilisierung der Polyamidschicht eingesetzten Stabilisatoren oder deren Abbauprodukte unter dem Einfluss von Temperatur und Feuchtigkeit in einem PV-Modul in die benachbarte EVA-Schicht migrieren können und dort mit nicht umgesetztem Peroxid reagieren, was zu einer unerwünschten Vergilbung führt. Peroxid ist in vernetzbarem EVA enthalten, damit solches EVA bei der heissen Laminierung chemisch vernetzt. Beispielsweise wird Dicumylperoxid eingesetzt.

Überraschenderweise wurde gefunden, dass diese Migration von Stabilisatormolekülen bzw. deren Abbauprodukten weitgehend unterbunden werden kann, wenn die PA-Matrix ein transparentes, bevorzugt amorphes PA enthält, dessen Glasübergangstemperatur auch nach Feuchtigkeitsaufnahme (bei 85°C und 85 % relativer Feuchtigkeit) noch oberhalb von 100°C liegt. Als besonders geeignet hat sich dabei PA MACM 12 erwiesen, das mit dem häufig in den PA-Rückfolien eingesetzten PA 12 gut verträglich ist.

Die erfindungsgemässen Rückfolien können Mono- oder Mehrschichtfolien sein. Bei Mehrschichtfolien ist die mindestens eine Schicht aus der erfindungsgemässen PA-Formmasse im laminierten PV-Modul benachbart zur EVA-Schicht. Sofern die Rückfolie aus mehreren Schichten besteht, sind neben der PA-Schicht oder zwischen zwei PA-Schichten bevorzugt Barriereschichten in der Rückfolie enthalten.

So kann eine Photovoltaikmodul-Mehrschichtrückfolie eine erste Aussenschicht, eine zweite Aussenschicht und eine zwischen diesen Aussenschichten angeordnete, eine Wasserdampfbarriere und/oder Sauerstoffbarriere bildende Innenschicht umfassen, wobei diese Schichten aus Polymeren aufgebaut sind. Zumindest die der EVA-Schicht benachbarte Aussenschicht, bevorzugt aber beide Aussenschichten der Rückfolie bestehen aus einer erfindungsgemässen Polyamidformmasse, wobei beide Aussenschichten in einer speziell bevorzugten Ausführungsform dieselben Polyamide enthalten. Bevorzugte Barriereschichten sind in der zum Prioritätszeitpunkt der vorliegenden Anmeldung noch nicht veröffentlichten Anmeldung EP 11159544.3 beschrieben.

Die vorliegende Erfindung wird anhand der nachfolgenden Beispiele, welche die Erfindung illustrieren, nicht aber den Erfindungsumfang einschränken sollen, näher dargestellt.

Die in Tabelle 1 aufgeführten Materialien wurden in den Beispielen und Vergleichsbeispielen eingesetzt.

**Tabelle 1: eingesetzte Materialien**

| Stoff | Handelsname | Hersteller | rel. Viskosität^{a)} | H₂O-Gehalt [Gew.-%] |
|---|---|---|---|---|
| PA MACM 12 | Grilamid TR® 90 | EMS-GRIVORY | 1.73 | 0.04 |
| PA 12 | Grilamid® L20 | EMS-GRIVORY | 1.90 | 0.05 |
| TiO₂ | Kronos® 2222 | Kronos-Titan | - | - |
| sterisch gehindertes Phenol | Irganox® 1098 | BASF | - | - |
| Diphosphonit | Sandostab® P-EPQ | Clariant | - | - |
| Diphosphit | Doverphos® S-9228 | Dover Chemical | - | - |
| UV-Absorber | Sanduvor® VSU | Clariant | - | - |
| sterisch gehindertes Amin | Nylostab® S-EED | Clariant | - | - |
| Gleitmittel | Mg-Stearat | Faci | - | - |

| | | | | |
|---|---|---|---|---|
| a) bestimmt nach ISO 307 (0.5 g Polyamid in 100 ml m-Kresol), Berechnung der relativen Viskosität (RV) nach RV = t/t₀ in Anlehnung an Abschnitt 11 der Norm. | | | | |

Bevorzugte UV- und Hitzestabilisatoren im Sinne der Erfindung sind Stabilisatoren ausgewählt aus der Gruppe bestehend aus den Klassen der Diphosphite, Diphosphonite, Oxanilide, sterisch gehinderten Aminen, sterisch gehinderten Phenolen und/oder Mischungen daraus. Besonders bevorzugte Vertreter aus diesen Klassen sind dabei Sandostab® P-EPQ ([4-[4-bis(2,4-ditert-butylphenoxy)phosphanylphenyl]phenyl]-bis(2,4-ditert-butylphenoxy)phosphan), Doverphos® S-9228 (Bis(2,4-dicumylphenyl)pentaerythritol diphosphit), Sanduvor® 312 (2-Ethyl-2'-ethoxy-oxalanilid), Nylostab® S-EED (1,3-Benzendicarboxamid, N,N'-bis(2,2,6,6-tetramethyl-4-piperidinyl) und Irganox® 1098 (N,N'-hexan-1,6-diylbis[3-(3, 5-di-tert-butyl-4-hydroxyphenyl)propionamid]).

### Beschreibung der Herstellung der in den Beispielen und Vergleichsbeispielen verwendeten PV-Modul-Testlaminate zur Untersuchung der Verfärbung,

Für die Herstellung der Photovoltaik-Modul-Testlaminate wurden folgende Produkte verwendet:
- Glasplatte: Optiwhite 6 mm (Diamant) gehärtetes Solarglas, 200 x 240 x 6 mm, geliefert von der Kurth Glas + Spiegel AG (Zuchwil, Schweiz)
- EVA-X-Folie (Folie aus vernetzbarem/vernetztem Ethylenvinylacetat-Copolymer): Vistasolar 486.10, Dicke 480 µm, geliefert von der Solutia Solar GmbH (Dietenheim, Deutschland). (Der Typ Vistasolar 486.10 wird in der PV-Modul-Produktion standardmässig eingesetzt und ist eine schnellvernetzende EVA-X-Folie ("fast cure"). Unter die Typenbezeichung ".10" fallen Folien bei denen beide Folienseiten bei Raumtemperatur nicht klebrig sind.) Die Folie wurde auf die Dimensionen der Glasplatte zurechtgeschnitten.
- Rückfolie (einschichtig) aus Polyamid-Formmassen von EMS (jeweils ausgewählt gemäss Tabelle 2 aus Materialien der Erfindungsbeispiele 1-6 sowie Materialien der Vergleichsbeispiele V1-V3). Foliendicke 300 pm. Die Formmassen wurden auf einem Zweiwellenextruder der Fa. Werner und Pfleiderer Typ ZSK25 hergestellt. Die jeweiligen Polyamid-Granulate wurden zusammen mit den Stabilisatoren in den Einzug und das Titandioxid mit einer Seitenförderung in die Schmelze dosiert. Die Gehäusetemperatur wurde als aufsteigendes Profil bis 270°C eingestellt. Bei einer Schneckendrehzahl von 200 Umdrehungen pro Minute wurden 12 kg Durchsatz pro Minute erreicht. Die Granulierung erfolgte mittels Stranggranulierung. Nach Trocknung bei 80°C für 24h wurden die Flachfolien hergestellt. Die Folienherstellung erfolgte auf einer Flachfolienanlage der Firma Dr. Collin GmbH (Ebersberg, Deutschland), Typ 3300, 3-Zonenschnecke mit 30 mm Durchmesser, L/D-Verhältnis = 25. Chill-Roll Typ 136/350. PA 12: Zylindertemperatur: 245-255°C, Kopftemperatur: 245°C. PA MACM 12 / PA 12: Zylindertemperatur: 265-275°C, Kopftemperatur: 260°C. PA MACM 12: Zylindertemperatur: 270-280°C, Kopftemperatur: 270-280°C. Die Folie wurde auf die Dimensionen der Glasplatte zurechtgeschnitten. Die Folien wurden vor der Weiterverarbeitung visuell auf Ihre Verwendbarkeit für ein PV-Modul beurteilt, geeignete Folien wurden in Tabelle 2 mit (+) und ungeeignete mit (-) bewertet.

Ein standardmässiger PV-Modul-Aufbau sieht zwei EVA-X-Folien vor, zwischen denen die Solarzellen eingekapselt sind. Sowohl für die erfindungsgemässen Beispiele als auch für die Vergleichsbeispiele wurde ein vereinfachter Aufbau gewählt, bei dem die EVA-X-Schicht zwischen der Glasplatte und der Solarzelle wie auch die Solarzelle selbst weggelassen wurde, so dass das Testlaminat aus einer Glasplatte und einer EVA-X-Folie und einer PA-Rückfolie gebildet wurde.

Als Laborpressanlage zur Herstellung der PV-Modul-Laminate wurde eine Tischpresse der Firma Fontijne-Grotnes (Vlaardingen, Niederlande), Typ Fontijne TP400, maximale Presskraft 400 kN, Plattengrösse (Werkzeugaufnahme) 320 mm x 320 mm, Pressenhub 200 mm, verwendet. In dieser Tischpresse befindet sich eine Werkzeugaufnahme mit einer Unter- und Oberseite, in welche die jeweiligen Matrizen für das Presswerkzeug eingelegt werden. Die Unterseite der Werkzeugaufnahme ist mit einem Hydraulikkolben verbunden, mit dem eine Presskraft auf das zu verpressende Produkt bzw. Laminat ausgeübt werden kann.

Die Pressanlage ist konstant auf 150 °C beheizt. Vor dem Einlegen der Glasplatte und der Folien wird die EVA-X-Folie sauber und gleichmässig auf die Glasplatte aufgelegt. Vorhandene Lufteinschlüsse werden durch Abstreifen zum Aussenrand hin entfernt. Nach dem Auflegen der Polyamid-Rückfolie auf die EVA-X-Folie werden die Ober- und Unterseite des Presslings (Glasplatte - EVA-X-Folie - PA-Folie), zum Schutz vor Deformation durch das Presswerkzeug und um eine homogene Ausübung des Drucks zu gewährleisten, mit einer 1 mm dicken PTFE-Folie versehen und in die Matrizen der Pressanlage eingelegt (mit der Glasplatte nach unten, damit diese beim Laminieren als starre Unterlage für die anderen Schichten dienen kann). Zwischen die PA-Folie und die obere 1 mm dicke PTFE-Folie wird eine weitere 110 µm dicke PTFE-Folie gelegt. Der Druck in der Presse wird nun mit Hilfe einer Vakuumpumpe auf 200 mbar (abs.) reduziert. Nach 5 Minuten wird die Vakuumpumpe abgeschaltet, der Druck von 200 mbar wird in der Pressanlage gehalten. Die Laminierzeit betrug 15 Minuten, wobei während dieser Zeit eine Presskraft von 10 kN den Pressling beaufschlagte. Nach der Presszeit wurde das System über ein Ventil entspannt, die PTFE-Folien entfernt und das fertige PV-Modul-Testlaminat aus der Pressanlage entnommen.

Im Produktionsmassstab unterscheidet sich die Herstellung nur durch die Handhabung der Folien und Glasplatten (abgesehen von der Grösse des PV-Moduls). Das Fördern zur Pressanlage, das Zurechtschneiden und Auflegen der Folie, das Entfernen von Luft und das Einlegen in die Pressanlage erfolgt maschinell. Die Presszeit ist abhängig vom Typ der verwendeten EVA-X-Folie.

### Bestimmung des Yellow Index

Der Yellow Index der EVA-X-Schicht wurde dann im laminierten Originalzustand durch die 6 mm dicke Glasplatte des PV-Modul-Testlaminats gemäss der Norm ASTM D1925 gemessen. Die Laminate wurden anschliessend während 1000 Stunden im Klimaschrank bei 85°C und 85 % relativer Feuchtigkeit gelagert. Der Yellow Index der EVA-Schicht wurde nach dieser Lagerung nochmals durch die Glasplatte hindurch gemessen. Die gemessenen Werte sind in der nachfolgenden Tabelle 2 eingetragen.

PA MACM 12 hat unter diesen Lagerungsbedingungen im Einklang mit Anspruch 1 eine Glasübergangstemperatur von 118 °C. Im trockenen Zustand liegt die Glasübergangstemperatur bei 155 °C.

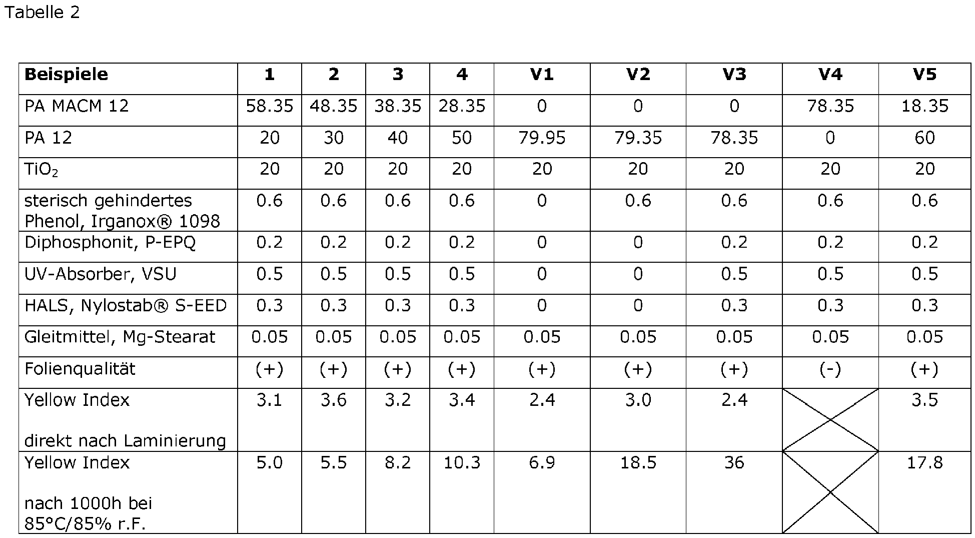

Wie aus Tabelle 2 ersichtlich ist, zeigen PV-Modul-Laminate, die in der PA-Schicht einer erfindungsgemässen Rückfolie einen PA MACM12-Anteil von mindestens 25 Gewichtsprozent aufweisen, eine ähnlich gute Farbstabilität wie eine PA12-Folie des Vergleichsbeispiels V1, die keine Stabilisatoren enthält (die migrieren könnten).

Aus PA MACM 12 (Vergleichsbeispiel V4, ohne PA 12) konnte auf Grund der schlechteren Verarbeitbarkeit keine geeignete Rückfolie für ein PV-Modul-Laminat erhalten werden. Zum Einen weist PA MACM 12 ein schlechteres Aufschmelzverhalten als PA 12 oder ein Blend aus PA MACM 12 und PA 12 auf, zum Anderen ist der Einzugstrom in den Extruder geringer. Um überhaupt eine Folie extrudieren zu können, musste mit einer Abzugswalzentemperatur von 135°C (im Vergleich zu <100°C für den Blend aus PA MACM 12 und PA12) gearbeitet werden. Bei derart hohen Abzugstemperaturen kommt es leicht zu Verklebungen; die erhaltene Folie wies eine sehr schlechte Qualität der Oberfläche und viele Wellen auf.

Der Hauptvorteil einer erfindungsgemässen Photovoltaik-Rückfolie zeigt sich vor allem darin, dass im Vergleich zum stark vergilbenden Vergleichsbeispiel V3 (ohne PA MACM 12, mit Stabilisatoren) die Vergilbung der erfindungsgemässen Beispiele (dank PA MACM12-Anteil im erfindungsgemässen Bereich) frappant gering ist.

Somit konnte das Problem der mit den PA-Stabilisatoren und der EVA-Haftvermittlerschicht zusammenhängenden Vergilbung in PV-Modul-Laminaten auf überraschende Weise durch eine Mischung von Polyamiden in der Formmasse der Polyamidschicht gemäss Anspruch 1 gelöst werden.

Diese Polyamidmischung verhindert weitgehend das Migrieren von Stabilisatormolekülen oder deren Abbauprodukten in die angrenzende Laminatschicht aus Ethylenvinylacetat (EVA), wo sie sonst mit nicht verbrauchtem Peroxid unter Gelbverfärbung reagieren könnten. Dank der erfindungsgemässen Massnahme erhält man ein einwandfreies PV-Modul, das auch bei Gebrauch in einer feuchtwarmen Umgebung nur sehr wenig vergilbt. Damit bleiben der Reflexionsgrad und der Wirkungsgrad des PV-Moduls hoch, und die ästhetischen Erwartungen des Konsumenten werden darüber hinaus erfüllt.

## Patentansprüche

1. Photovoltaikmodul-Rückfolie, welche mindestens eine Schicht enthält die aus einer Polyamid-Formmasse hergestellt ist, **dadurch gekennzeichnet, dass** diese Polyamid-Formmasse zusammengesetzt ist aus:
- 25 bis 70 Gewichtsprozent mindestens eines transparenten Polyamids (A), dessen Glasübergangstemperatur auch nach der Aufnahme von Feuchtigkeit bei 85°C und 85 % relativer Feuchtigkeit mehr als 100°C beträgt;
- 15 bis 58 Gewichtsprozent mindestens eines aliphatischen Polyamids (B);
- 0.5 bis 3 Gewichtsprozent an UV- und Hitzestabilisatoren (C); und
- 10 bis 30 Gewichtsprozent mindestens eines weiteren Zusatzstoffes (D); wobei sich die Komponenten (A) bis (D) auf 100 Gewichtsprozent der Polyamid-Formmasse ergänzen.

2. Photovoltaikmodul-Rückfolie gemäss Anspruch 1, **dadurch gekennzeichnet, dass** das mindestens eine transparente Polyamid (A) ausgewählt ist aus einer Gruppe, die aus PA MACM 12, PA PACM 12, PA MACM I, PA MACM T und Mischungen daraus besteht, und dass das mindestens eine aliphatische Polyamid (B) ausgewählt ist aus einer Gruppe, die aus PA 11, PA 12, PA 1010, PA 1012 und Mischungen daraus besteht.

3. Photovoltaikmodul-Rückfolie gemäss Anspruch 1 oder 2, **dadurch gekennzeichnet, dass** das mindestens eine transparente Polyamid (A) amorph ist.

4. Photovoltaikmodul-Rückfolie gemäss einem der vorhergehenden Ansprüche, **dadurch gekennzeichnet, dass** die Polyamid-Formmasse in ihrer Zusammensetzung eine Mischung von 26 bis 68 Gewichtsprozent des Polyamids (A) und 16 bis 50 Gewichtsprozent des Polyamids (B), bevorzugt von 28 bis 65 Gewichtsprozent des Polyamids (A) und 17 bis 40 Gewichtsprozent des Polyamids (B) und besonders bevorzugt von 53 bis 63 Gewichtsprozent des Polyamids (A) und 18 bis 30 Gewichtsprozent des Polyamids (B) enthält, wobei sich die Gewichtsprozente jeweils auf 100 Gewichtsprozent der Polyamid-Formmasse beziehen, die auch die Komponenten (C) und (D) enthält.

5. Photovoltaikmodul-Rückfolie gemäss einem der vorhergehenden Ansprüche, **dadurch gekennzeichnet, dass** die Polyamidformmasse keine anderen Polyamide als PA MACM 12 und PA 12 enthält.

6. Photovoltaikmodul-Rückfolie gemäss einem der vorhergehenden Ansprüche, **dadurch gekennzeichnet, dass** die UV- und Hitzestabilisatoren (C) ausgewählt sind aus der Gruppe bestehend aus den Klassen der Diphosphite, Diphosphonite, Oxanilide, sterisch gehinderten Aminen, sterisch gehinderten Phenolen und Mischungen daraus, und bevorzugt ausgewählt sind aus der Gruppe bestehend aus [4-[4-bis(2,4-ditert-butylphenoxy)phosphanylphenyl] phenyl]-bis(2,4-ditert-butylphenoxy)phosphan; Bis(2,4-dicumylphenyl)pentaerythritol diphosphit; 2-Ethyl-2'-ethoxy-oxalanilid; 1,3-Benzendicarboxamid, N,N'-bis(2,2,6,6-tetramethyl-4-piperidinyl; N,N'-hexan-1,6-diylbis [3-(3, 5-di-tert-butyl-4-hydroxyphenyl)propionamid] und Mischungen daraus.

7. Photovoltaikmodul-Rückfolie gemäss einem der vorhergehenden Ansprüche, **dadurch gekennzeichnet, dass** der mindestens eine weitere Zusatzstoff (D) ausgewählt ist aus einer Gruppe, die aus Weisspigmenten, UV-Absorbern, Hydrolysestabilisatoren, Vernetzungsaktivatoren, Flammschutzmitteln, Schichtsilikaten, Füllstoffen, Farbmitteln, Verstärkungsmitteln, Haftvermittlern, Schlagzähigkeitsmodifikatoren, Gleitmitteln, Fluorpolymeren und Mischungen daraus besteht.

8. Photovoltaikmodul-Rückfolie gemäss Anspruch 7, **dadurch gekennzeichnet, dass** sie mindestens ein Weisspigment enthält und einen Reflexionsgrad von mindestens 92 % aufweist.

9. Photovoltaikmodul-Rückfolie gemäss Anspruch 7 oder 8, **dadurch gekennzeichnet, dass** das Weisspigment Titandioxid in der Rutil- oder Anatas-Modifikation ist.

10. Photovoltaikmodul-Rückfolie gemäss Anspruch 9, **dadurch gekennzeichnet, dass** Titandioxid in einem Anteil von 15 bis 25 Gewichtsprozent, bevorzugt von 18 bis 22 Gewichtsprozent und besonders bevorzugt von 19 bis 21 Gewichtsprozent enthalten ist.

11. Photovoltaikmodul-Rückfolie gemäss einem der vorhergehenden Ansprüche, **dadurch gekennzeichnet, dass** die Rückfolie aus einer einzigen Schicht oder aus mehreren Schichten besteht.

12. Photovoltaikmodul-Rückfolie gemäss einem der vorhergehenden Ansprüche, **dadurch gekennzeichnet, dass** die mindestens eine Schicht der Rückfolie, die aus einer Polyamid-Formmasse hergestellt ist, in einem laminierten Photovoltaikmodul direkt an eine Schicht aus Ethylenvinylacetat (EVA) grenzt.

13. Photovoltaikmodul mit einer Photovoltaikmodul-Rückfolie gemäss einem der vorhergehenden Ansprüche, **dadurch gekennzeichnet, dass** es einen Yellow Index aufweist, der nach 15-minütigem Laminieren bei einer Pressentemperatur von 150°C und anschliessender Lagerung des Photovoltaikmoduls während 1000 Stunden bei 85°C und 85 % relativer Feuchtigkeit kleiner als 11, bevorzugt kleiner als 9 und besonders bevorzugt kleiner als 6 ist.

14. Verfahren zur Herstellung einer Photovoltaikmodul-Rückfolie, welche mindestens eine Schicht enthält die aus einer Polyamid-Formmasse hergestellt ist, insbesondere gemäss einem der Ansprüche 1 bis 12, **dadurch gekennzeichnet, dass** die Polyamid-Formmasse zusammengesetzt ist aus:
- 25 bis 70 Gewichtsprozent mindestens eines transparenten Polyamids (A), dessen Glasübergangstemperatur auch nach der Aufnahme von Feuchtigkeit bei 85°C und 85 % relativer Feuchtigkeit mehr als 100°C beträgt,
- 15 bis 58 Gewichtsprozent mindestens eines aliphatischen Polyamids (B),
- 0.5 bis 3 Gewichtsprozent an UV- und Hitzestabilisatoren (C), und
- 10 bis 30 Gewichtsprozent mindestens eines weiteren Zusatzstoffes (D), wobei sich die Komponenten (A) bis (D) auf 100 Gewichtsprozent der Polyamid-Formmasse ergänzen, und die Polyamid-Formmasse extrudiert oder coextrudiert wird.

15. Verwendung einer Photovoltaikmodul-Rückfolie gemäss einem der Ansprüche 1 bis 12 oder eines Verfahrens zu deren Herstellung gemäss Anspruch 14 bei der Produktion photovoltaischer Module.

## Geänderte Patentansprüche

### Geänderte Patentansprüche gemäss Regel 137(2) EPÜ.

**1.** Photovoltaikmodul-Rückfolie, welche mindestens eine Schicht enthält die aus einer Polyamid-Formmasse hergestellt ist, **dadurch gekennzeichnet, dass** diese Polyamid-Formmasse zusammengesetzt ist aus:
- 25 bis 70 Gewichtsprozent mindestens eines transparenten Polyamids (A), dessen Glasübergangstemperatur auch nach der Aufnahme von Feuchtigkeit bei 85°C und 85 % relativer Feuchtigkeit mehr als 100°C beträgt;
- 15 bis 58 Gewichtsprozent mindestens eines aliphatischen Polyamids (B);
- 0.5 bis 3 Gewichtsprozent an UV- und Hitzestabilisatoren (C); und
- 10 bis 30 Gewichtsprozent mindestens eines weiteren Zusatzstoffes (D); wobei sich die Komponenten (A) bis (D) auf 100 Gewichtsprozent der Polyamid-Formmasse ergänzen.

**2.** Photovoltaikmodul-Rückfolie gemäss Anspruch 1, **dadurch gekennzeichnet, dass** das mindestens eine transparente Polyamid (A) ausgewählt ist aus einer Gruppe, die aus PA MACM 12, PA PACM 12, PA MACM I, PA MACM T und Mischungen daraus besteht, **und dass** das mindestens eine aliphatische Polyamid (B) ausgewählt ist aus einer Gruppe, die aus PA 11, PA 12, PA 1010, PA 1012 und Mischungen daraus besteht.

**3.** Photovoltaikmodul-Rückfolie gemäss Anspruch 1 oder 2, **dadurch gekennzeichnet, dass** das mindestens eine transparente Polyamid (A) amorph ist.

**4.** Photovoltaikmodul-Rückfolie gemäss einem der vorhergehenden Ansprüche, **dadurch gekennzeichnet, dass** die Polyamid-Formmasse in ihrer Zusammensetzung eine Mischung von 26 bis 68 Gewichtsprozent des Polyamids (A) und 16 bis 50 Gewichtsprozent des Polyamids (B) enthält, wobei sich die Gewichtsprozente jeweils auf 100 Gewichtsprozent der Polyamid-Formmasse beziehen, die auch die Komponenten (C) und (D) enthält.

**5.** Photovoltaikmodul-Rückfolie gemäss einem der vorhergehenden Ansprüche, **dadurch gekennzeichnet, dass** die Polyamidformmasse keine anderen Polyamide als PA MACM 12 und PA 12 enthält.

**6.** Photovoltaikmodul-Rückfolie gemäss einem der vorhergehenden Ansprüche, **dadurch gekennzeichnet, dass** die UV- und Hitzestabilisatoren (C) ausgewählt sind aus der Gruppe bestehend aus den Klassen der Diphosphite, Diphosphonite, Oxanilide, sterisch gehinderten Aminen, sterisch gehinderten Phenolen und Mischungen daraus.

**7.** Photovoltaikmodul-Rückfolie gemäss einem der vorhergehenden Ansprüche, **dadurch gekennzeichnet, dass** der mindestens eine weitere Zusatzstoff (D) ausgewählt ist aus einer Gruppe, die aus Weisspigmenten, UV-Absorbern, Hydrolysestabilisatoren, Vernetzungsaktivatoren, Flammschutzmitteln, Schichtsilikaten, Füllstoffen, Farbmitteln, Verstärkungsmitteln, Haftvermittlern, Schlagzähigkeitsmodifikatoren, Gleitmitteln, Fluorpolymeren und Mischungen daraus besteht.

**8.** Photovoltaikmodul-Rückfolie gemäss Anspruch 7, **dadurch gekennzeichnet, dass** sie mindestens ein Weisspigment enthält und einen Reflexionsgrad von mindestens 92 % aufweist.

**9.** Photovoltaikmodul-Rückfolie gemäss Anspruch 7 oder 8, **dadurch gekennzeichnet, dass** das Weisspigment Titandioxid in der Rutil- oder Anatas-Modifikation ist.

**10.** Photovoltaikmodul-Rückfolie gemäss Anspruch 9, **dadurch gekennzeichnet, dass** Titandioxid in einem Anteil von 15 bis 25 Gewichtsprozent enthalten ist.

**11.** Photovoltaikmodul-Rückfolie gemäss einem der vorhergehenden Ansprüche, **dadurch gekennzeichnet, dass** die Rückfolie aus einer einzigen Schicht oder aus mehreren Schichten besteht.

**12.** Photovoltaikmodul mit einer Photovoltaikmodul-Rückfolie gemäss einem der vorhergehenden Ansprüche, **dadurch gekennzeichnet, dass** die mindestens eine Schicht der Rückfolie, die aus einer Polyamid-Formmasse hergestellt ist, in einem laminierten Photovoltaikmodul direkt an eine Schicht aus Ethylenvinylacetat (EVA) grenzt.

**13.** Photovoltaikmodul mit einer Photovoltaikmodul-Rückfolie gemäss einem der vorhergehenden Ansprüche, **dadurch gekennzeichnet, dass** es einen Yellow Index aufweist, der nach 15-minütigem Laminieren bei einer Pressentemperatur von 150°C und anschliessender Lagerung des Photovoltaikmoduls während 1000 Stunden bei 85°C und 85 % relativer Feuchtigkeit kleiner als 11 ist, gemessen gemäss der Norm ASTM D1925 durch eine 6 mm dicke Glasplatte hindurch.

**14.** Verfahren zur Herstellung einer Photovoltaikmodul-Rückfolie, welche mindestens eine Schicht enthält die aus einer Polyamid-Formmasse hergestellt ist, insbesondere gemäss einem der Ansprüche 1 bis 12, **dadurch gekennzeichnet, dass** die Polyamid-Formmasse zusammengesetzt ist aus:
- 25 bis 70 Gewichtsprozent mindestens eines transparenten Polyamids (A), dessen Glasübergangstemperatur auch nach der Aufnahme von Feuchtigkeit bei 85°C und 85 % relativer Feuchtigkeit mehr als 100°C beträgt,
- 15 bis 58 Gewichtsprozent mindestens eines aliphatischen Polyamids (B),
- 0.5 bis 3 Gewichtsprozent an UV- und Hitzestabilisatoren (C), und
- 10 bis 30 Gewichtsprozent mindestens eines weiteren Zusatzstoffes (D), wobei sich die Komponenten (A) bis (D) auf 100 Gewichtsprozent der Polyamid-Formmasse ergänzen, und die Polyamid-Formmasse extrudiert oder coextrudiert wird.

**15.** Verwendung einer Photovoltaikmodul-Rückfolie gemäss einem der Ansprüche 1 bis 12 oder eines Verfahrens zu deren Herstellung gemäss Anspruch 14 bei der Produktion photovoltaischer Module.
